## Europäisches Patentamt

## European Patent Office

## Office européen des brevets

(19)

(11) Veröffentlichungsnummer: **0 368 293**

**A2**

(12) # EUROPÄISCHE PATENTANMELDUNG

(21) Anmeldenummer: **89120727.6**

(22) Anmeldetag: **08.11.89**

(51) Int. Cl.5: **H05K 13/04**

(30) Priorität: **10.11.88 DE 3838173**

(43) Veröffentlichungstag der Anmeldung:
**16.05.90 Patentblatt 90/20**

(84) Benannte Vertragsstaaten:
**AT BE CH DE ES FR GB GR IT LI LU NL SE**

(71) Anmelder: **Nixdorf Computer Aktiengesellschaft Fürstenallee 7 D-4790 Paderborn(DE)**

(72) Erfinder: **Ellerbrok, Wolfgang Hövelwiese 22 D-4794 Hövelhof(DE)**

(74) Vertreter: **Schaumburg, Thoenes & Englaender Mauerkircherstrasse 31 Postfach 86 07 48 D-8000 München 86(DE)**

(54) **Verfahren und Einrichtung zum Bestücken von Leiterplatten.**

(57) In einem Verfahren zum Bestücken von Leiterplatten (26) mit elektronischen Bauelementen (20) und einer Einrichtung zum Durchführen des Verfahrens werden die Bauelemente (20) durch eine mit den Positionen und Formen der Bauelemente (20) entsprechenden Durchbrechungen (18) versehene Lochplatte (10) hindurch auf eine Unterlage aufgelegt und auf dieser in der vorgesehenen Anordnung bis zur Fixierung auf der Leiterplatte (26) gehalten. Hierbei wird eine mit Durchbrechungen (18) einer Form und Größe versehene Lochschablone (10) über eine Leiterplatte (26) positioniert und auf die Lochschablone (10) wird vorzugsweise eine über der Anzahl der Durchbrechungen (18) liegende Anzahl von Bauelementen (20) eines Typs aufgeschüttet. Die Lochschablone (10) wird dann nach Art eines Vibrationsförderers in Schwingungen versetzt, so daß die Bauelemente über den Durchbrechungsbereich der Lochschablone wandern, wobei durch jede Durchbrechung (18) ein Bauelement (20) fällt. Darauf wird die Lochschablone (10) von der Leiterplatte (26) abgehoben und die auf der Leiterplatte (26) liegenden Bauelemente (20) werden mit der Leiterplatte (26) elektrisch kontaktiert und verbunden.

Fig. 4.

## Verfahren und Einrichtung zum Bestücken von Leiterplatten

Die Erfindung betrifft ein Verfahren gemäß dem Oberbegriff des Anspruches 1 und eine Einrichtung zur Durchführung des Verfahrens.

Verfahren der im Oberbegriff des Anspruches 1 genannten Art werden vor allem bei der sogenannten SMD-Bestückungstechnik (SMD = Surface Mounted Device) angewendet, bei welcher Bauteile ohne Drahtanschlüsse direkt auf die Leiterplattenoberfläche aufgelegt und mit dieser verlötet werden.

Aus der DE 30 48 780 A1 ist ein Verfahren und eine Vorrichtung der gattungsgemäßen Art bekannt. Dort wird eine Leiterplatte mit einer Vielzahl unterschiedlicher elektrischer Bauelemente an vorbestimmten Positionen bestückt. Die Bauelemente sind hierbei in Fallschächten angeordnet und werden durch eine Lochschablone mit zu den jeweiligen Bauelementen passenden Durchbrechungen auf einer Unterlage mit Vertiefungen für die Aufnahme der Bauelemente abgelegt. Die Vertiefungen sind so ausgebildet, daß die jeweiligen Bauelemente teilweise aus ihnen herausragen. Durch mechanisches Vibrieren von Unterlage und Lochschablone werden die Bauelemente auf der Unterlage ausgerichtet. Die Lochschablone wird sodann abgehoben und eine an vorbestimmten Oberflächenbereichen mit Klebstoff versehene Leiterplatte wird dann auf die mit den Bauelementen bestückte Unterlage aufgelegt, wobei die Bauelemente an den mit Klebstoff bestrichenen Oberflächenbereichen haften bleiben. Die Leiterplatte wird daraufhin von der Unterlage abgehoben und die Bauelemente werden mit der Leiterplatte verlötet.

Dieses Verfahren ermöglicht eine Bestückung von Leiterplatten mit Bauteilen unterschiedlicher Art und Form, da die eigentliche Festlegung der einzelnen Bauteilepositionen schon durch die diesen Positionen entsprechende Anordnung der Fallschächte bzw. Zuführmagazine erfolgt. Die Erstellung der Einrichtung für das bekannte Verfahren ist äußerst aufwending und teuer, da für jede Bauteilposition ein eigener Fallschacht vorgesehen werden muß, und zwar auch dann, wenn vorwiegend oder sogar ausschließlich wert- und baugleiche Bauteile verwendet werden. Weiterhin ist durch die Anordnung der Zuführmagazine ein bestimmter Mindestabstand der Durchbrechungen in der Führungsplatte notwendig, der aufgrund der Abmessungen der Zuführmagazine nicht unterschritten werden kann. Weiterhin ist für die Bestückung einer Leiterplatte bei dem bekannten Verfahren eine Unterlage mit Vertiefungen und eine Führungsplattee notwendig, die beide positioniert und in Vibration versetzt werden müssen. Hierfür ist jedoch eine komplizierte und kostenaufwendige Vorrichtung erforderlich.

Es ist die Aufgabe der Erfindung, ein Verfahren der gattungsgemäßen Art und eine Einrichtung zur Durchführung dieses Verfahrens anzugeben, welche eine einfache und kostengünstige Bestückung von Leiterplatten mit einer hohen Bestückungsdichte ermöglicht.

Diese Aufgabe wird bei einem Verfahren der gattungsgemäßen Art durch die kennzeichnenden Merkmale des Anspruches 1 gelöst.

Das erfindungsgemäße Verfahren zielt darauf ab, jeweils wert-und bauformgleiche Bauelemente für eine Leiterplatte in einem gesonderten, gegenüber dem bekannten Verfahren jedoch erheblich vereinfachten Verfahrensdurchgang auf der Leiterplatte zu positionieren. Dabei besteht z.B. die Möglichkeit, für alle vorgesehenen Bauteiltypen je einen derartigen Verfahrensdurchgang vorzusehen, bis die Bestückung beendet ist. Es ist jedoch vorwiegend darin gedacht, nur die in großer Zahl vorgesehenen Bauteiletypen (z.B. Abblockkondensatoren) durch das erfindungsgemäße Verfahren aufzubringen, die übrigen, nach Wert und Bauform stark unterschiedlichen Bauteile in konventioneller Bestückungstechnik zu positionieren.

Ein wesentlicher Vorteil des erfindungsgemäßen Verfahrens wird auch darin gesehen, daß wegen des Fehlens von Fallschächten die Durchbrechungen sehr dicht über die Lochschablone verteilt sein können, so daß auch die erzielbare Bestückungsdichte sehr hoch ist.

Weitere vorteilhafte Weiterbildungen des Verfahrens sind in den Unteransprüchen 2 bis 7 enthalten.

In dem erfindungsgemäßen Verfahren werden zur Bestückung von Leiterplatten jeweils wert- und bauformgleiche, für die Simultanbestückung geeignete anschlußdrahtlose Bauelemente auf eine Lochschablone aufgeschüttet. Die Lochschablone weist Durchbrechungen in der Anordnung der Bestückungspositionen der Bauelemente auf der Leiterplatte auf und wird mit ihren Durchbrechungen über den Bestückungspositionen einer zu bestückenden Leiterplatte positioniert. Darauf wird sie nach Art eines Vibrationsförderers in Schwingungen versetzt. Hierbei wandern die Bauelemente ungeordnet über die Lochschablone. Die Anzahl der Bauelemente wird wesentlich höher gewählt als die Anzahl der Durchbrechungen. Die Anzahl der Bauelemente zu Beginn des Bestückungsvorganges sollte so gewählt werden, daß sie die ganze Breite der Lochschablone einnehmen und in mehreren Reihen hintereinander liegen, damit mit großer Sicherheit durch jede Durchbrechung der Lochschablone ein Bauelement auf die Leiterplatte fällt.

Die Lochschablone wird in einem Abstand über der Leiterplatte gehalten, der etwas kleiner als die Höhe der Bau elemente ist. Wenn ein Bauelement durch eine Durchbrechung gefallen ist, ragt es noch mit seiner Oberseite über die Lochschablone hinaus, wodurch nachfolgende Bauelemente um die bereits besetzte Durchbrechung herumgeleitet werden. Die Leiterplatte ist zumindest an den Anlötstellen für die Bauelement mit Lotpaste beschichtet, wodurch auf die Leiterplatte gefallene Bauelemente in ihrer Lage fixiert werden. Wenn der Bestückungsvorgang beendet ist, wird die Lochschablone von der Leiterplatte abgehoben. Die Bauelemente können nun mit der Leiterplatte z.B. durch Erhitzen verlötet werden.

In einer vorteilhaften Ausgestaltung des erfindungsgemäßen Verfahrens werden die Bauelemente auf eine an einem ersten Schablonenrand befindliche Schüttzone aufgegeben. Beim Positionieren der Lochschablone über der Leiterplatte wird die Lochschablone leicht geneigt, so daß der die Bauelemente aufnehmende erste Schablonenrand leicht erhöht liegt und der gegenüberliegende zweite Schablonenrand tiefer liegt. Nun wird die Lochschablone nach Art eines Vibrationsförderers in Schwingungen versetzt, so daß die Bauelemente von dem ersten Schablonenrand zum gegenüberliegenden zweiten Schablonenrand wandern. Wenn die Bauelemente am anderen Schablonenrand angelangt sind, wird die Lochschablone von der Leiterplatte abgehoben. Beim nächsten Bestückungsvorgang wird dann beispielsweise die Lochschablone in die entgegengesetzte Richtung geneigt, wodurch die Bauelemente, die sich am zweiten Schablonenrand gesammelt haben sowie gegebenenfalls zusätzlich auf den zweiten Schablonenrand aufgeschüttete Bauelemente, wieder in Richtung des ersten Schablonenrandes wandern, wobei ein Teil durch die vorgesehenen Durchbrechungen fällt.

Da die Förderrichtung durch die jeweilige Neigung der Lochschablone bestimmt wird, kann diese in technisch sehr einfach zu verwirklichender Weise senkrecht zur Schablonenfläche in Schwingungen versetzt werden.

Das erfindungsgemäße Verfahren kann in vorteilhafter Weise in einer Einrichtung gemäß Anspruch 7 durchgeführt werden. Weitere vorteilhafte Ausgestaltungen dieser Einrichtung sind Gegenstand der Unteransprüche 8 bis 17.

Die erfindungsgemäße Einrichtung hat eine Vorrichtung zur Aufnahme einer Leiterplatte und zur Positionierung der Leiterplatte unter der Lochschablone. Ferner ist eine Einrichtung zum Auflegen von Bauelementen auf der Lochschablone vorgesehen. Die Lochschablone ist außerdem mit einem Vibrationsantrieb gekoppelt, mit dem sie entsprechend einem Vibrationsförderer in Schwingungen versetzt werden kann.

Damit wird bewirkt, daß auf die Lochschablone aufgelegte Bauelemente in der jeweils vorgesehenen Förderrichtung über die Oberfläche der Lochschablone gefördert werden, wobei jeweils ein Bauteil durch jede Durchbrechung hindurch auf die Leiterplatte fällt.

Im Gegensatz zur bekannten Einrichtung ist bei der erfindungsgemäßen Einrichtung keine Unterlage mit Vertiefungen zur vorläufigen Aufnahme der Bauelemente notwendig; vielmehr werden die Bauelemente direkt auf der Leiterplatte positioniert, so daß die Anzahl der Verfahrensschritte verringert und die Einrichtung vereinfacht werden kann.

Es ist vorteilhaft, wenn die Leiterplatten über eine Fördereinrichtung zu- und abgeführt werden. Die Zu- und Abführung kann dann mit einer Positioniereinrichtung für die Lochschablone synchronisiert werden.

Die Bauelemente können ungeordnet auf die Lochschablone aufgeschüttet werden. Um die Anzahl der auf der Lochschablone be findlichen Bauelemente in bestimmten Grenzen zu halten, ist es vorteilhaft, die Schütteinrichtung zum Aufschütten der Bauelemente auf die Lochschablone mit einer Regeleinrichtung zu versehen. Diese weist hierbei Zähler zum Erfassen der auf die Lochschablone aufgeschütteten Bauelemente und Zähler zum Zählen der Bestückungsvorgänge, beispielsweise durch Zählen der zugeführten Leiterplatten, auf. Eine elektronische Steuerungsvorrichtung kann durch diese Werte die Zufuhr an Bauelementen so regeln, daß ein gewünschter Überschuß an Bauelementen immer auf der Lochschablone vorhanden ist. Die Lochschablone ist in vorteilhafter Weise ähnlich einer Siebdruckschablone aufgebaut. Sie besteht aus einem Spannrahmen und einer in dem Spannrahmen über ein Spann-Netz eingespannten geätzten Metallschablone. Für jeden Leiterplattentyp und Bauelemententyp ist eine eigene Lochschablone vorgesehen. Die photographischen Masken für das Ätzen der Durchbrechungen einer Lochschablone können gleichzeitig, z.B. in einem CAD-System mit der Leiterplatte entwickelt werden. Durch das in dem Spannrahmen aufgehängte Siebgewebe sind die Lochschablonen formstabil und können leicht in einer Bestückungseinrichtung ausgewechselt werden.

Es ist vorteilhaft, an zwei gegenüberliegenden Schablonenrändern jeweils eine durchbrechungsfreie Schüttzone bzw. Depotfläche für die Bauelemente vorzusehen. Die Bauelemente können dann bei aufeinanderfolgenden Bestückungsvorgängen immer zwischen den beiden Depotflächenrändern hin und her zu wandern, wobei sie den Bereich mit den Durchbrechungen durchlaufen. Hierbei ist es vorteilhaft, wenn die Schüttzonen und der Durchbrechungsbereich der Lochschablone von dem jeweils nicht benötigten Bereich einer Lochschablone durch Leiteinrichtungen getrennt sind, so daß die Bauelemente von diesem nicht benötigten Bereich ferngehalten werden. Hierdurch kann die Anzahl der auf die Lochschablone aufgeschütteten Bauelemente geringgehalten werden.

Eine exakte Lage der Lochschablone über der Leiterplatte läßt sich mittels an der Lochschablone und an der Leiterplatte angeordneter Führungseinrichtungen einstellen, mit denen ihre Lage relativ zueinander justierbar ist. Diese Führungseinrichtungen können beispielsweise als Winkelanschläge oder als Indexierbolzen ausgebildet sein, die in jeweils zugeordnete Indexierbohrungen eingreifen.

Durch Anordnen mehrerer erfindungsgemäßer Einrichtungen hintereinander läßt sich eine Leiterplatte mit unterschiedlichen Typen von Bauelementen bestücken. Die Bestückung von Leiterplatten mit verschiedenartigen Bauelementen läßt sich jedoch auch in einer erfindungsgemäßen Einrichtung durchführen, wenn diese mehrere wahlweise aktivierbare Einrichtungen zum Aufschütten von elektrischen Bauelementen und mehrere gegebeinander austauschbare Lochschablonen für unterschiedliche elektrische Bauelemente aufweist. So können z.B. zuerst Widerstände auf einer Leiterplatte aufgebracht werden. Danach wird die nicht mehr benötigte Lochschablone abgehoben und eine zweite Lochschablone zum Bestücken der Leiterplatte z.B. mit Kondensatoren über der Leiterplatte positioniert. Während sich eine Lochschablone über der Leiterplatte befindet, können z.B. die entsprechenden Bauelemente auf die andere Lochschablone aufgeschüttet werden. Die Einrichtung hat hierbei vorteilhafterweise eine Halteeinrichtung zur auswechselbaren Aufnahme unterschiedlicher Lochschablonen. Somit muß nicht für jede Lochschablone eine eigene Halteeinrichtung vorgesehen werden. Hierdurch wird die Anlage einfacher, kompakter und kostengünstiger.

Die Erfindung wird anhand von Ausführungsbeispielen mit den zugehörigen Zeichnungen erläutert. Es zeigen:

Figure 1 eine perspektivische, schematische Ansicht einer Lochschablone;

Figur 2 eine vergrößerte Draufsicht auf den zentralen Teil der Lochschablone aus Figur 1;

Figur 3 schematisch eine Seitenansicht einer Bestükkungseinrichtung mit einer Leiterplatte und einer darüber angeordneten Lochschablone;

Figur 4 eine Seitenansicht gemäß Figur 3 nach dem Bestücken der Leiterplatte;

Figur 5 eine Seitenansicht gemäß Figur 3 beim Abheben der Lochschablone von der Leiterplatte und

Figur 6 schematisch eine perspektivische Ansicht einer Leiterplatte, einer Zuführvorrichtung für die Leiterplatte und einer Lochschablone mit Führungselementen.

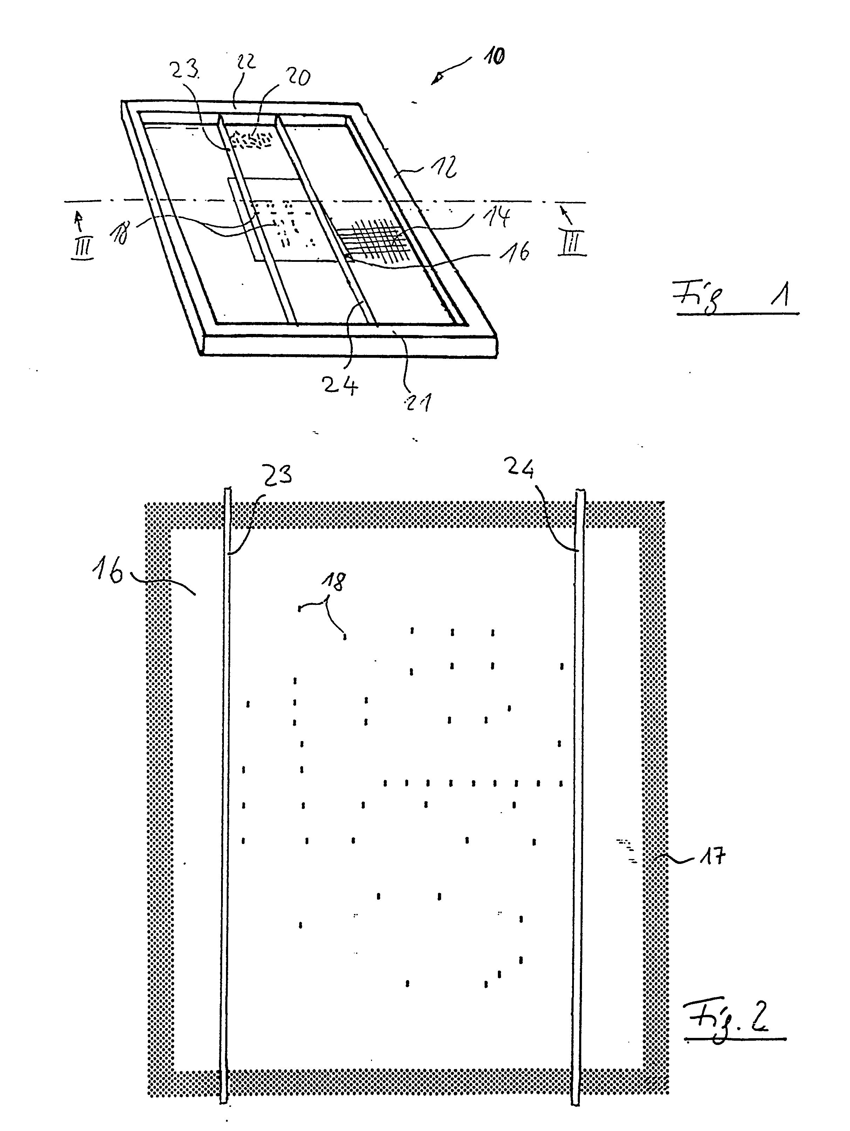

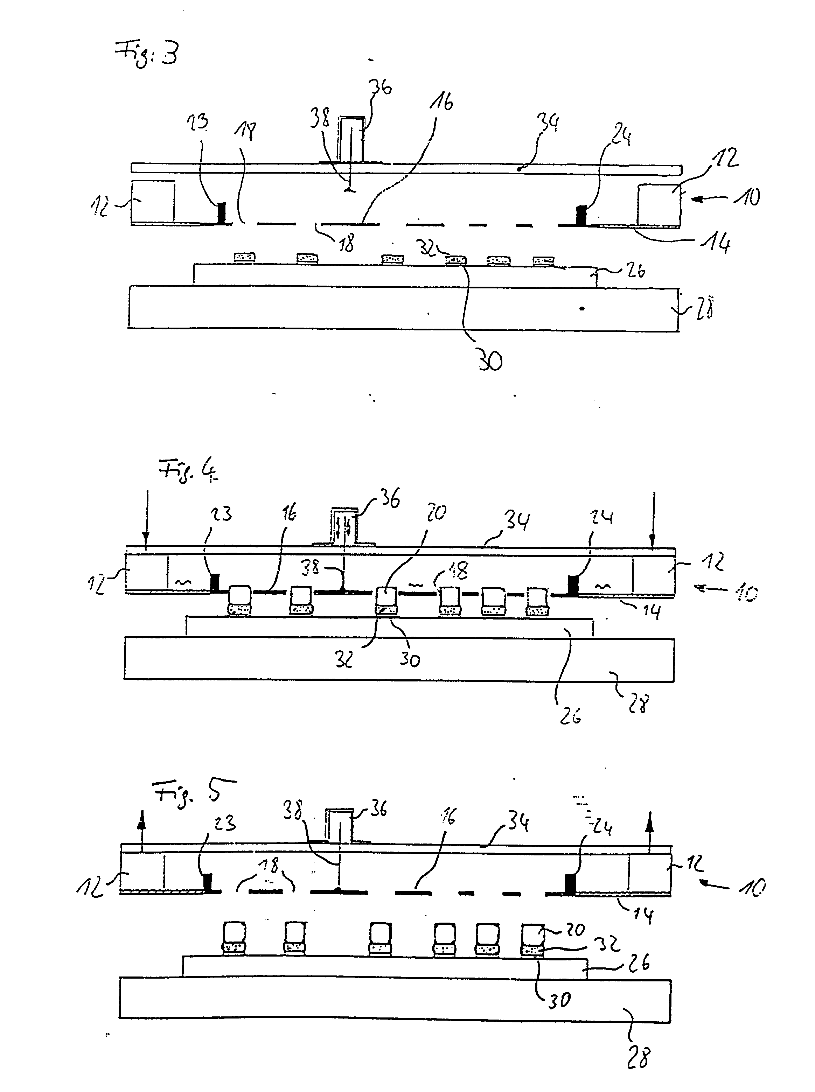

Figur 1 zeigt eine Lochschablone 10, wie sie in dem erfindungsgemäßen Verfahren verwendet wird. Die Lochschablone 10 ist in dieser Ausführung ähnlich einer Siebdruckschablone ausgebildet. Sie besteht aus einem Metallrahmen 12, in dem ein Kunststoff- oder Metallnetz 14 eingespannt ist. Das Netz 14 trägt seinerseits in seinem zentralen Bereich eine Metallfolie 16. Aus dieser Metallfolie 16 sind Durchbrechungen 18 in der Form und Größe von Bauelementen 20 herausgeätzt, mit denen eine Leiterplatte bestückt werden soll. Die Durchbrechungen können beispielsweise in einem chemischen Verfahren herausgeätzt werden, wobei die Masken für das Ätzverfahren in einem CAD-Entwicklungssystem mit der Leiterplatte generiert werden können. Die Lochschablone 10 ist rechteckig, wobei am hinteren Längsende 22 die Bauelemente 20 auf die Lochschablone 10 aufgeschüttet und durch Vibration zum vorderen Ende 21 transportiert werden. Die Seitenbereiche der Lochschablone 10 sind außerhalb des mit Durchbrechungen versehenen Bereiches der Metallfolie 16 mit parallel zu den Längsseiten verlaufenden Begrenzungsleisten 23, 24 abgetrennt, damit sich die auf die Lochschablone 10 aufgeschütteten Bauelemente 20 lediglich über den Bereich der Durchbrechungen 18 verteilen (siehe auch Figur 2).

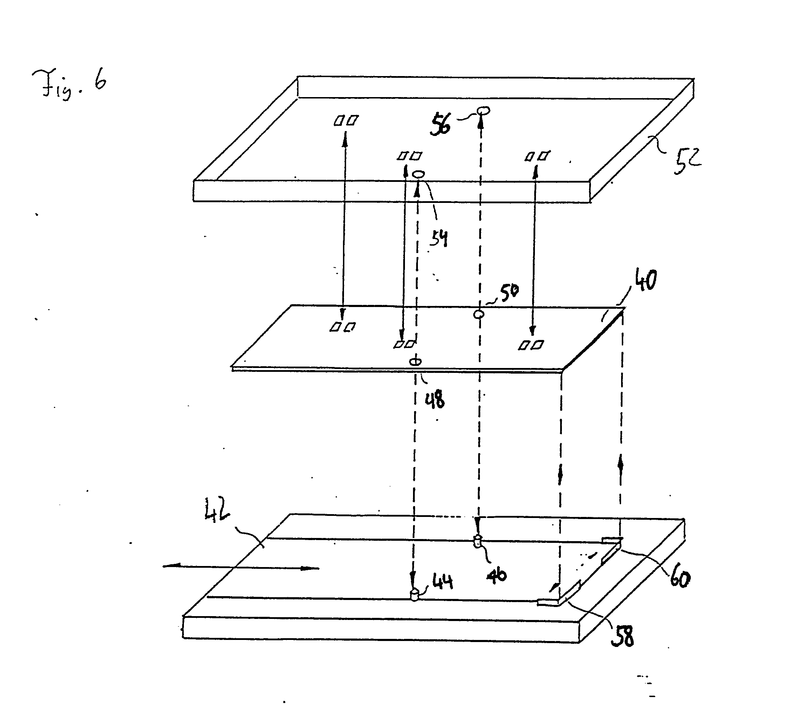

Figur 3 bis Figur 5 zeigen schematisch den Verfahrensablauf beim Bestücken einer Leiterplatte 26.

Die Leiterplatte 26 liegt hierbei auf einer Aufnahmevorrichtung 28, z.B. einem Förderband auf. Die Leiterplatte 26 hat Anschlußstellen 30 für die Kontaktierung mit den Bauelementen 20, mit denen sie bestückt werden soll. Die Anschlußstellen 30 sind mit Lotpaste 32 versehen. Diese kann in einem Druckverfahren vorher auf die Leiterplatte 26 aufgedruckt werden. Die an einem Längsende 22 mit Bauelementen 20 belegte Lochschablone 10, die in Figur 3 entsprechend dem Schnitt III-III aus Figur 1 dargestellt ist, wird nun in einem höchstens der Höhe der Bauelemente 20 entsprechenden Abstand über der Leiterplatte 26 positioniert und ein wenig in Richtung auf das dem Längsende 22 gegenüberliegende Längsende 21 geneigt. Auf die Lochschablone 10 wird eine Schwingplatte 34 mit einem elektromagnetischen oder piezoelektrischen Schwingungserreger 36 abgesenkt, die an dem Rahmen 12 der Lochschablone 10 anliegt (Figur 4). Der Schwingungserreger 36 hat einen Fortsatz 38, der an der Metallplatte 16 der Lochschablone 10 anliegt, wenn die Schwingplatte 34 an dem Rahmen 12 anliegt. Der Schwingungserreger 36 erzeugt nun eine senkrecht zum Lochschablonenboden gerichtete Schwingung, wodurch sich die Bauelemente entsprechend der Neigung der Lochschablone 10 von einem Längsende 22 zum anderen Längsende 21 der Lochschablone 10 bewegen. Da die Anzahl der auf die Lochschablone 10 aufgegebenen Bauelemente 20 die Anzahl der in der Lochschablone 10 enthaltenen Durchbrechungen 18 wesentlich übersteigt, fällt bei diesem Vorgang durch jede Durchbrechung 18 jeweils ein Bauelement 20. Da die Höhe der Lochschablone 10 über die Leiterplatte 26 höchstens gleich der oder geringer als die Höhe der Bauelemente 20 ist, wird jede Durchbrechung 18, durch die bereits ein Bauelement 20 gefallen ist, von diesem gesperrt. Die Lochschablone 10 wird durch den Schwingungserreger 26 so lange in Vibration versetzt, bis die Bauelemente 20 den Bereich der Durchbrechungen 18 verlassen haben und am anderen Längsende 21 der Lochschablone 10 angelangt sind. Die auf die Leiterplatte 26 gefallenen Bauelemente 20 werden durch die aufgetragene Lotpaste 32 auf ihren Lötstellen 20 gehalten. Nun wird die Lochschablone 10 mit der Schwingungsplatte 34 von der Leiterplatte 26 abgehoben (Figur 5) und die Bauelemente 20 können mit der Leiterplatte 26 kontaktiert bzw. verlötet werden.

Für eine korrekte elektrische Kontaktierung ist es wichtig, die Lochschablone exakt über der Leiterplatte zu positionieren. Dies kann durch eine in Figur 6 beschriebene Anordnung erfolgen. In dieser Anordnung wird eine Leiterplatte 40 auf einem Förderband 42 transportiert. Auf dem Förderband 42 sind Indexierbolzen 44, 46 angeordnet, die in entsprechend angeordnete Indexierbohrungen 48, 50 der Leiterplatte 40 eingreifen. In der Lochschablone 52, die wie die Lochschablone 10 in Figur 1 ausgebildet sein kann, sind ebenfalls Indexierbohrungen 54, 56 in einer den Indexierbolzen 44, 46 entsprechenden Anordnung vorhanden. Diese Indexierbohrungen 54, 56 werden beim Positionieren der Lochschablone 52 über der Leiterplatte 40 von den Indexierbolzen 44, 46 des Förderbandes durchsetzt. Hierdurch wird eine exakte Positionierung der Lochschablone 52 über der Leiterplatte 40 erreicht. Das Förderband 42 kann ebenfalls Anschlagkanten 58, 60 als Führungen für die Leiter platte 40 und die Lochschablone 52 aufweisen. Auch hierdurch wird eine exakte Positionierung der Lochschablone 52 relativ zu der Leiterplatte 40 erreicht.

Zur Bestückung einer Leiterplatte mit mehreren unterschiedlichen Bauelementen können nacheinander verschiedene Lochschablonen über der Leiterplatte angeordnet werden. Dies kann durch Hintereinanderschalten mehrerer oben dargestellter Bestückungseinrichtungen realisiert werden. Eine Bestükkungseinrichtung für eine Leiterplatte kann jedoch auch mehrere Lochschablonen für unterschiedliche Bauelemente aufweisen, die nacheinander über der Leiterplatte positioniert werden. Es ist ebenfalls vorstellbar, eine große Anzahl gleichartiger Bauelemente mit dem erfindungsgemäßen Verfahren auf einer Leiterplatte aufzubringen und danach speziellere Bauelemente in einer geringeren Anzahl durch eine konventionelle Bestückungsvorrichtung mit Fallschächten oder dergleichen auf die Leiterplatte aufzubringen.

Die Herstellung der Lochschablone erfolgt in der Weise, daß zunächst das Netz 14 in den Metallrahmen 12 gespannt wird. Die geätzte Metallfolie 16 ist in ihrem Randbereich mit geätzten Lochfeldern 17 versehen. Die Metallfolie wird auf das Netz 14 aufgelegt und die Lochfelder 17 werden mit dem Netz verklebt. Anschließend wird der zentrale Teil des Netzes 14, der innerhalb der Lochfelder 17 liegt, herausgeschnitten, wobei die Spannung des Netzes 14 sich auf die Metallfolie 16 überträgt.

## Ansprüche

1. Verfahren zum Bestücken von Leiterplatten (26) mit elektronischen Bauelementen (20) insbesondere vom SMD-Typ, wobei die Bauelemente (20) mittels einer vibrierend angetriebenen Lochschablone (10) mit den Positionen der Bauelemente entsprechend angeordneten und deren Formen entsprechend ausgebildeten Durchbrechungen (18) in ihre Bestückungsanordnung gebracht und in dieser Anordnung mit einer Leiterplatte verbunden sowie elektrisch kontaktiert werden, dadurch gekennzeichnet, daß zum Bestücken der jeweiligen Leiterplatte (26) mit Bauelementen (20) eines Typs eine Lochschablone (10) mit Durchbrechungen (18) übereinstimmender, den Abmessungen der Bauelemente entsprechender Form und Größe über einer Leiterplatte (26) angeordnet wird, daß die Bauelemente (20) auf die Lochschablone (10) aufgelegt werden und daß die Lochschablone (10) nach Art eines Vibrationsförderers in Schwingungen versetzt wird, wobei die Lochschablone (10) in einem Abstand über der Leiterplatte (26) positioniert wird, der kleiner als oder höchstens gleich der Höhe der Bauelemente (20) ist.

2. Verfahren nach Anspruch 1, dadurch gekennzeichnet, daß die Bauelemente (20) auf eine Schüttzone im Bereich eines ersten Schablonenrandes (22) aufgeschüttet und über die Lochschablone (10) zu einem dem ersten Schablonenrand (22) gegenüberliegenden zweiten Schablonenrand (21) gefördert werden.

3. Verfahren nach Anspruch 2, dadurch gekennzeichnet, daß die Bauelemente (20) bei aufeinanderfolgenden Bestückungsvorgängen (26) abwechselnd vom ersten Schablonenrand (22) zum zweiten Schablonenrand (21) bzw. umgekehrt gefördert werden.

4. Verfahren nach einem der Ansprüche 1 bis 3, dadurch gekennzeichnet, daß die Lochschablone (10) in vertikale Schwingungen versetzt und in Förderrichtung gegen die Horizontale gekippt wird.

5. Einrichtung zur Durchführung des Verfahrens nach einem der vorhergehenden Ansprüche, umfassend eine vibrierend antreibbare Lochschablone (10) mit den Positionen der Bauelemente entsprechend angeordneten und deren Formen entsprechend ausgebildeten Durchbrechungen (18), dadurch gekennzeichnet, daß unter der Lochschablone (10) eine Vorrichtung zur Aufnahme der jeweiligen Leiterplatte (26) angeordnet ist, daß die Lochschablone (10) mit einem Vibrationsantrieb nach Art eines Vibrationsförderers gekoppelt ist und daß eine Einrichtung zum Auflegen von Bauelementen (20) auf die Lochschablone (10) vorgesehen ist.

6. Einrichtung nach Anspruch 5, dadurch gekennzeichnet, daß eine Fördereinrichtung (42) zum Zu- und Abführen der Leiterplatte (40) in eine Position unterhalb der Lochschablone (52) bzw. aus dieser Position heraus vorgesehen ist.

7. Einrichtung nach Anspruch 5 oder 6, dadurch gekennzeichnet, daß sie wenigstens eine Schütteinrichtung zum Aufschütten von Bauelementen auf die Lochschablone hat und daß die Schütteinrichtung mit einer Regeleinrichtung zum Regeln der Schüttmenge versehen ist.

8. Einrichtung nach Anspruch 7, dadurch gekennzeichnet, daß die Regeleinrichtung Zähler zum Erfassen der Menge der aufgeschütteten Bauelemente (20) und zum Zählen der zu- bzw. abgeführten Leiterplatten aufweist.

9. Einrichtung nach einem der Ansprüche 5 bis 8, dadurch gekennzeichnet, daß die Lochschablone (10) an mindestens einem Schablonenrand (21, 22) eine durchbrechungsfreie Schüttzone hat, auf den die Bauelemente (20) aufgeschüttet werden, und daß die Lochschablone (10) um eine parallel zu diesem Schablonenrand (21, 22) ausgerichtete Achse neigbar ist.

10. Einrichtung nach einem der Ansprüche 5 bis 9, dadurch gekennzeichnet, daß die Lochschablone (10) Leiteinrichtungen (23, 24) zum Leiten der Bauelemente (20) von der jeweiligen Schüttzone in den Bereich der Durchbrechungen (18) aufweist.

11. Einrichtung nach einem der Ansprüche 5 bis 10, dadurch gekennzeichnet, daß die Lochschablone (10) zumindest in ihrem Mittelbereich (16) aus einem metallischen Material besteht, und daß die Durchbrechungen (18) aus diesem Bereich (16) herausgeätzt sind.

12. Einrichtung nach einem der Ansprüche 7 bis 11, gekennzeichnet durch mehrere wahlweise aktivierbare Schütteinrichtungen für unterschiedliche Bauelemente (20) und mehrere den unterschiedlichen Bauelementen entsprechende auswechselbare Lochschablonen, sowie durch eine Halteeinrichtung zum auswechselbaren Aufnehmen unterschiedlicher Lochschablonen.

Fig. 1

Fig. 2

Fig. 3

Fig. 4

Fig. 5

Fig. 6